# EUROPEAN PATENT APPLICATION

(11) **EP 4 589 636 A1**
(43) Date of publication of application: **23.07.2025**
(21) Application number: 24222449.1
(22) Date of filing: 20.12.2024
(51) Int. Cl.: H01L 21/48, H01L 23/498

(54) **MANUFACTURING METHOD FOR PACKAGING SUBSTRATE**

(30) Priority: 27.12.2023 KR 20230192645
(71) Applicant: Absolics Inc., Covington, GA 30014 (US)
(72) Inventor: LEE, Jong Hyun, 18469 Hwaseong-si, Gyeonggi-do (KR); KIM, Jincheol, 18469 Hwaseong-si, Gyeonggi-do (KR); KANG, JUIN, 18469 Hwaseong-si, Gyeonggi-do (KR)
(74) Representative: BCKIP Part mbB

(57) **Abstract**

A manufacturing method for a packaging substrate is provided. The manufacturing method includes a preparation step of preparing a base substrate including a core layer including an upper surface and a through-hole formed in a thickness direction of the core layer, a via insulating portion forming step of forming a via insulating portion in the through-hole to prepare a via-plugged substrate, and a fabrication step of fabricating a packaging substrate from the via-plugged substrate.

## Description

This application claims the priority of Republic of Korea patent application No. 10-2023-0192645 filed on December 27, 2023.

### BACKGROUND

### Technical Field

The present disclosure relates to a manufacturing method for a packaging substrate.

### Description of Related Art

In manufacturing electronic components, implementing a circuit on a semiconductor wafer is called a front-end (FE) process, assembling the wafer in a state of being usable in an actual product is called as a back-end (BE) process, and a packaging process is included in the back-end process.

The four core technologies of the semiconductor industry, which recently enabled rapid development of electronic products, include semiconductor technology, semiconductor packaging technology, manufacturing process technology, and software technology. Semiconductor technology has developed in various forms, such as nanoscale (submicron) line widths, 10 million cells or more, high-speed operation, large heat dissipation, and the like, but the packaging technology does not support the semiconductor technology perfectly. Accordingly, the electrical performance of a semiconductor can sometimes be determined by the packaging technology and an electrical connection according to the packaging technology rather than the performance of the semiconductor technology itself.

Recently, research on applying ceramic material to a high-end packaging substrate is in progress. A line length between an element and a motherboard can be shortened and excellent electrical characteristics can be achieved by forming a through hole in a ceramic substrate and applying a conductive material to the through hole.

### SUMMARY

A manufacturing method for a packaging substrate according to an embodiment of the present specification includes a preparation step of preparing a base substrate including a core layer including an upper surface and a through-hole formed in a thickness direction of the core layer, a via insulating portion forming step of forming a via insulating portion in the through-hole to prepare a via-plugged substrate, and a fabrication step of fabricating a packaging substrate from the via-plugged substrate.

The core layer may be a glass core.

The through-hole may be formed in the core layer in two or more.

The through-hole may have a diameter of 40 µm to 200 µm.

The through-hole may have a pitch of 50 µm to 1,500 µm.

The via insulating portion forming step may include a filling process of filling the through-hole with a composition for forming the via insulating portion by screen printing and a curing process of curing the composition for forming the via insulating portion to form the via insulating portion.

The composition for forming the via insulating portion may have a viscosity of 100 dPa·s to 500 dPa·s.

The via insulating portion forming step may further include a descum process of plasma-descumming the via-plugged substrate.

The via insulating portion may include one end located on an upper surface side of the core layer.

The via-plugged substrate may have a trench structure in which the one end of the via insulating portion is located lower than the upper surface of the core layer.

The trench structure of the via-plugged substrate may have a depth of 1 µm to 15 µm.

The packaging substrate may include the core layer having the through-hole formed in the thickness direction of the core layer and a via insulating portion formed in the through-hole.

The via insulating portion may include a filler.

The filler may have an average particle diameter of 0.1 µm to less than 15 µm.

The via insulating portion may have an elongation of 0.1% to 5%.

The composition for forming the via insulating portion may include an epoxy-based resin, a curing agent, and a filler.

The packaging substrate may include the core layer having the through-hole formed in the thickness direction of the core layer, a via insulating portion formed in the through-hole, and a first insulating layer formed in contact with at least part of the upper surface of the core.

The first insulating layer may have a dimple depth of 15 µm or less.

### BRIEF DESCRIPTION OF THE DRAWINGS

FIG. 1A is a sectional view illustrating a core layer applied to an embodiment of the present specification;
FIG. 1B is a sectional view illustrating a core layer applied to another embodiment of the present specification;
FIGs. 2A and 2B are sectional views illustrating a filling process applied to an embodiment of the present specification;
FIG. 3A is a conceptual view illustrating a via-plugged substrate after a descum process according to an embodiment of the present specification;
FIG. 3B is a conceptual view illustrating a via-plugged substrate after a descum process according to another embodiment of the present specification;
FIG. 4 is a sectional view illustrating a packaging substrate fabricated in accordance with an embodiment of the present specification;
FIGs. 5A to 5C are graphs showing the surface profiles of through-holes included in upper surfaces of packaging substrates of examples;
FIGs. 6A to 6C are graphs showing the surface profiles of through-holes included in lower surfaces of the packaging substrates of the examples; and
FIG. 7 is a transmission electron microscope (TEM) image of a packaging substrate of an example in which an insulating layer is formed.

### DESCRIPTION OF THE EMBODIMENTS

Embodiments will be described in detail such that the embodiments can be easily implemented by a person having ordinary skill in the art to which the embodiments pertain. However, embodiments may be implemented in various other forms and are not limited to the embodiments described herein. Throughout the specification, similar parts are denoted by the same reference numerals.

Throughout this specification, the term "combination thereof' as used in a Makushi-style representation is intended to mean at least one or combination selected from the group of components described in the Makushi-style representation, including one or more selected from the group of components.

Throughout this specification, terms such as "first" and "second" or "A" and "B" are used to distinguish one from another. In addition, singular forms are intended to include plural forms unless mentioned otherwise.

As used herein, reference to a "- based" may mean that a compound includes a compound corresponding to the "-" or a derivative of the "-".

As used herein, reference to B being located on A means that B may be located on A in direct contact therewith or that B may be located on A in the state in which another layer is interposed therebetween, and is not to be construed as being limited to B being located on A in surface contact therewith.

As used herein, reference to B being connected to A means that B may be directly connected to A or that B may be connected to A in the state in which another layer is interposed therebetween, and is not to be construed as being limited to B being connected to A unless mentioned otherwise.

In this specification, singular expressions are construed to include singular forms or plural forms as interpreted from the context unless otherwise indicated.

In the drawings, the shapes, relative sizes, angles, etc. of the configurations are exemplary and may be exaggerated for purposes of illustration and shall not be construed as limiting the rights to the drawings.

In this specification, when A and B are adjacent, this means that A and B are disposed in contact with each other or that A and B are not in contact with each other but are close to each other. In this specification, the expression "A and B are adjacent" shall not be construed to mean that A and B are disposed in contact with each other unless otherwise indicated.

As used herein, the term "fine line" means a line having a width of 5 µm or less, unless otherwise specified, and exemplarily means a line having a width of 1 to 4 µm.

In order to optimize a signal transmission path, a core layer having a through-hole formed in a thickness direction of the core layer may be introduced to a packaging substrate. However, when a redistribution layer is implemented on the core layer, a defect that may cause a misalignment of the redistribution layer, such as a part of an insulating layer disposed on the core layer being indented or wrinkled in a wave-like manner, may occur when the insulating resin is impregnated into an inner space of the through-hole.

The inventors of the present disclosure have experimentally found that it is possible to inhibit the misalignment of the redistribution layer and to fabricate a packaging substrate with excellent electrical reliability by applying technical features such as forming a via insulating portion in the through-hole, and have completed the embodiments.

Hereinafter, the present disclosure will be described.

### Preparation step

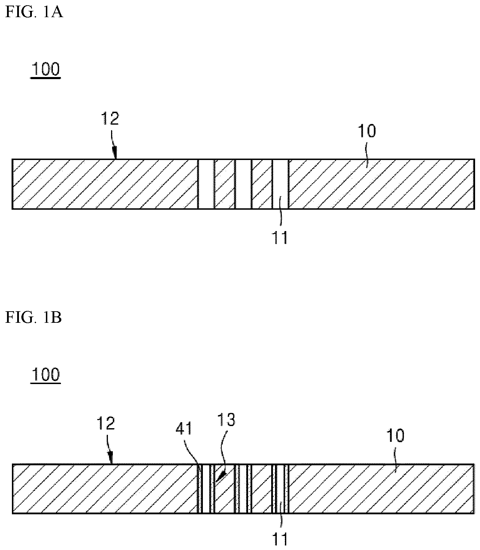

FIG. 1A is a sectional view illustrating a core layer applied to an embodiment of the present specification. The embodiment will be described with reference to FIG. 1A.

A manufacturing method for a packaging substrate according to an embodiment includes a preparation step of preparing a base substrate 100 including a core layer 10 having an upper surface 12 and a through-hole 11 formed in a thickness direction of the core layer 10.

The core layer 10 may have the shape of a substrate. The core layer 10 is not restricted as long as the core layer is a substrate that can be applied as an electronic component.

The core layer 10 may be any one of a glass core, a ceramic core, a fiberglass reinforced core, and an organic core. In particular, the core layer 10 may be a glass core. The glass core is one embodiment in that it is possible to implement a fine pattern and to reduce the possibility of parasitic elements.

For example, alkaline borosilicate plate glass, alkali-free borosilicate plate glass, or alkali-free alkaline earth metal borosilicate plate glass may be used as the glass core. A glass substrate for electronic devices may be used as the glass core. For example, a glass substrate from SCHOTT, AGC, or Coming may be used; however, the embodiment is not limited thereto.

The surface of the core layer 10 may include an upper surface 12 and a side surface connected to the upper surface 12, the side surface being formed in the thickness direction of the core layer 10. The surface of the core layer 10 may include a lower surface opposite the upper surface 12.

The side surface being formed in the thickness direction of the core layer 10 is interpreted to mean not only that the side surface forms a perpendicular to the upper surface 12 of the core layer 10 but also that at least a part of the side surface forms an angle (inclination angle) other than 90 degrees to the upper surface 12.

The side surface may be flat or curved.

The through-hole 11 may be formed in the thickness direction of the core layer 10.

The through-hole 11 may have a substantially uniform inner diameter in the thickness direction of the core layer 10. The through-hole 11 may have an inner diameter that varies in the thickness direction of the core layer 10.

The section of the through-hole 11 may have a rectangular shape. The section of the through-hole 11 may have an hourglass shape, a triangular shape, or a trapezoidal shape. The section of the through-hole 11 refers to a section in the thickness direction of the core layer 10.

In the preparation step, a core layer 10 having a through-hole 11 formed therein may be obtained and prepared, or a core layer 10 may be prepared by forming a through-hole 11 in a substrate having no through-hole.

In particular, a method of preparing a core layer 10 by forming a through-hole 11 in a substrate made of glass is as follows.

A defect may be formed in the surface of the substrate made of glass at the position where the through-hole is disposed. Mechanical etching or laser radiation may be used as a method of forming the defect.

After forming the defect, the through-hole 11 may be formed by physical or chemical etching. If chemical etching is used, wet etching using an etching solution may be performed. The etching solution is not restricted as long as it is possible to etch the glass substrate. For example, a sulfuric acid solution, a nitric acid solution, or a hydrofluoric acid solution may be used as the etching solution.

During the etching process, the rest of the surface of the glass substrate except for the region where the defect is formed may be masked, or the etching may be performed without masking.

A defect may be formed at one point in the upper surface of the glass substrate, and a defect may be formed at another point in the lower surface of the glass substrate opposite the one point, and etching may be performed in directions facing each other to provide a core layer 10 having a through-hole 11.

The ratio of the thickness of the core layer 10 to the diameter of the through-hole 11 observed from the upper surface 12 of the core layer may be 4 to 12.

In a via insulating portion forming step, the through-hole 11 may be filled with a composition for forming a via insulating portion in direction from the upper surface 12 side of the core layer to the through-hole 11. At this time, the composition may not be filled uniformly throughout the region of the through-hole 11 to be filled, and a defect such as a void may be formed in the formed via insulating portion.

In the present disclosure, it is possible to control the ratio of the thickness of the core layer 10 to the diameter of the through-hole 11 to be within a predetermined range in order to inject the composition for forming the via insulating portion in the region of the through-hole 11 to be filled with substantially no void.

The ratio of the thickness of the core layer 10 to the diameter of the through-hole 11 observed from the upper surface 12 of the core layer may be 4 to 12. The ratio may be 5 or more. The ratio may be 7 or more. The ratio may be 11 or less. In these cases, formation of the void in the via insulating portion may be substantially inhibited, and may help fabricate a packaging substrate with improved integration.

The core layer 10 may include two or more through-holes 11. In the case of a core layer 10 made of glass in which a plurality of through-holes is formed, packing density of fine-diameter through-holes 11 in the core layer 10 may be proportional to vulnerability of the core layer to external impact. When a packaging substrate is fabricated using the core layer 10 having the above structure, physical damage to the core layer 10 may occur due to external force applied to the core layer 10 during a process of fabricating the packaging substrate, in particular during the process of injecting the composition for forming the via insulating portion into the through-holes 11 by screen printing.

In the present disclosure, it is possible to apply an adjusted diameter and pitch to the through-hole 11. This may allow wirings penetrate the core layer 10 to be formed in the packaging substrate with high density and may inhibit cracking of the core layer 10 that may occur during the fabrication process.

When the through-hole 11 has a diameter that varies in the thickness direction of the core layer 10, the average value of the diameter is designated to the diameter of the through-hole 11.

The diameter of the through-hole 11 may be 40 µm to 200 µm. The diameter may be 50 µm or more. The diameter may be 70 µm or more. The diameter may be 170 µm or less. The diameter may be 150 µm or less. The diameter may be 130 µm or less.

The pitch of the through-hole 11 may be 50 µm to 1,500 µm. The pitch may be 100 µm or more. The pitch may be 200 µm or more. The pitch may be 300 µm or more. The pitch may be 500 µm or more. The pitch may be 1200 µm or less. The pitch may be 1000 µm or less.

In these cases, the core layer 10 may not be easily damaged during the fabrication process even if a material with high hardness and a complex structure are applied to the core layer 10.

FIG. 1B is a sectional view illustrating a core layer applied to another embodiment of the present specification. The embodiment will be described with reference to FIG. 1B.

The core layer 10 includes an upper surface 12 and a through-hole 11 formed in the thickness direction of the core layer 10. The specific configuration of the core layer 10 is the same as described with reference to FIG. 1A. Hereinafter, differences will be described.

The core layer 10 may include a via inner-diameter surface 13 surrounding the through-hole 11. An electrically conductive layer 41 may be formed on the via inner-diameter surface 13.

The via inner-diameter surface 13 is the surface of the core layer 10 formed on the inside of the core layer 10. The electrically conductive layer 41 may be formed in a state of at least partially abutting the via inner-diameter surface 13, or may be disposed on the via inner-diameter surface 13 in the state in which another component is disposed between the electrically conductive layer 41 and the via inner-diameter surface 13.

The electrically conductive layer 41 may include a seed layer (or primer layer) (not shown) disposed on the via inner-diameter surface 13 and a conductive layer (not shown) disposed on the seed layer. The seed layer (or primer layer) may help stably fix the electrically conductive layer 41 to the via inner-diameter surface 13, and may function as a seed during a process of forming the conductive layer through plating.

The electrically conductive layer 41 may be formed using a dry method or a wet method.

In the dry method, the seed layer is formed by sputtering in the region where the electrically conductive layer 41 is to be disposed, and the electrically conductive layer 41 is formed by plating in the region where the seed layer is formed. When forming the seed layer, a metal, such as titanium, chromium, or nickel, may be sputtered, and copper may be sputtered after forming the seed layer of the above metal. Sputtering may create an anchor effect in which metal particles interact with the surface of the glass core or the insulating layer, which may improve adhesion of the electrically conductive layer 41.

In the wet method, a primer is applied to the part where the electrically conductive layer 41 is to be formed, followed by metal plating. The primer may include a compound having a functional group such as amine. Depending on the degree of adhesion desired, the primer may include a compound having a functional group such as amine and a silane coupling agent. When the silane coupling agent is applied, the surface to be primed may be pretreated with the silane coupling agent and the compound having the amine group may be applied to the pretreated region to form a primer layer.

After forming the seed layer or the primer layer, the conductive layer may be formed by metal plating to provide the electrically conductive layer 41. For forming the conductive layer, copper plating may be used; however, the embodiment is not limited thereto. Before metal plating, the part of the seed layer or the primer layer that does not require formation of the electrically conductive layer 41 may be deactivated, or the part that requires formation of the electrically conductive layer 41 may be activated and then plating may be performed. Light radiation such as irradiation with a laser having a specific wavelength or chemical treatment may be used as the activation or deactivation method. However, after metal plating is performed without activation or deactivation, the electrically conductive layer 41 may be etched and patterned according to a predesigned shape.

A material applied to the conductive layer and a material different from the material applied to the conductive layer may be used together as the material of the seed layer. For example, when copper is applied to the conductive layer, a metal such as titanium, chromium, or nickel may be applied to a lower part of the seed layer, and copper may be applied to an upper part of the seed layer.

The material for the conductive layer is not restricted as long as the material has conductivity. The material for the conductive layer may be any one selected from the group consisting of copper, nickel, aluminum, gold, silver, and a combination thereof. The material for the conductive layer may be copper.

The thickness of the electrically conductive layer 41 disposed in the through-hole 11 may be 0.01 µm to 1 µm. The thickness may be 0.05 µm or more. The thickness may be 0.1 µm or more. The thickness may be 0.3 µm or more. The thickness may be 0.8 µm or less. In these cases, efficient and stable signal transmission is possible through the through-hole 11.

The core layer 10 may further include a cavity (not shown), which is a space depressed inward.

The cavity may be formed as a result of a part of the upper surface/lower surface of the core layer 10 being depressed in the thickness direction of the core layer 10, or may be formed through the core layer 10 in the thickness direction of the core layer 10.

An element may be mounted in the cavity, and the packaging substrate and the element may be electrically connected to each other. The element may be not only a semiconductor element, such as a CPU, a GPU, or a memory chip, but also a capacitor element, a transistor element, an impedance element, and any other modules. That is, any semiconductor element mounted on a semiconductor device may be used as the element without limitation.

### Via insulating portion forming step

The method of fabricating the packaging substrate according to the embodiment further includes a via insulating portion forming step of forming a via insulating portion in the through-hole to prepare a via-plugged substrate.

The via insulating portion may substantially include no void therein and may be formed by filling at least a part of the through-hole. The via insulating portion may inhibit a resin constituting the insulating layer is sucked excessively into the through-hole during a process of forming the insulating layer on an upper side of the core layer. This may help to stably maintain the flatness of the upper surface of the insulating layer. In addition, when an electrically conductive layer is formed on the via inner-diameter surface, the electrically conductive layer may be reliably protected and fixed, and the electrical reliability of the fabricated packaging substrate may be maintained at a certain level or higher.

The via insulating portion forming step may include a filling process of filling the through-hole with the composition for forming the via insulating portion by screen printing and a curing process of curing the composition for forming the via insulating portion to form the via insulating portion.

### 1) Filling process

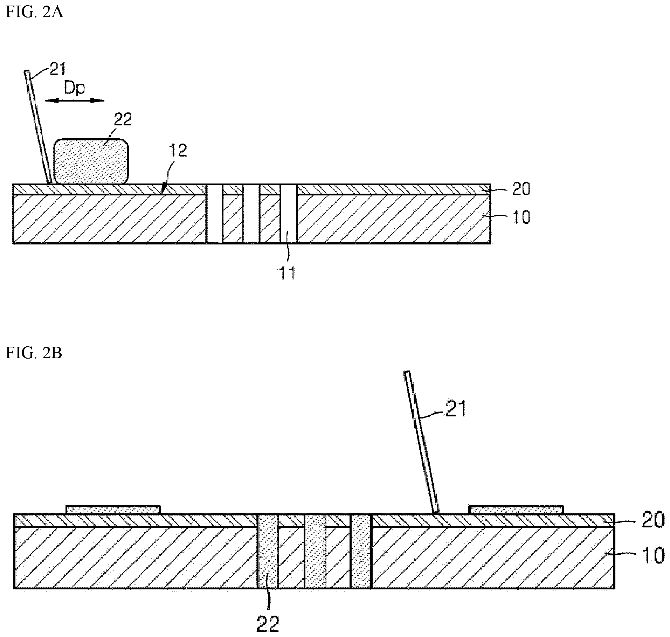

FIGs. 2A and 2B are sectional views illustrating a filling process applied to an embodiment of the present specification. The embodiment will be described with reference to FIGs. 2A and 2B.

A core layer 10 includes an upper surface 12 and a through-hole 11 formed in the thickness direction of the core layer 10. The specific configuration of the core layer 10 is the same as described with reference to FIG. 1A. Hereinafter, differences will be described.

In the filling process, the through-hole 11 may be filled with a composition for forming a via insulating portion 22 by screen printing. Specifically, a screen 20 having a pattern corresponding to the position of the through-hole 11 may be installed on the core layer 10, and the through-hole 11 may be filled with the composition for forming a via insulating portion 22 by squeezing the composition for forming a via insulating portion 22 in an in-plane direction Dp of a base substrate 100 using a squeegee 21.

The material for the screen may be, but is not limited to, a nylon resin, a polyester resin, or stainless steel.

In the present disclosure, it is possible to adjust the viscosity of the composition for forming the via insulating portion 22 applied during the filling process. This may allow the through-hole 11 to be easily filled with the composition for forming a via insulating portion 22 without clogging, and may prevent the filled composition for forming a via insulating portion 22 from being easily dislodged from the through-hole 11.

The viscosity of the composition for forming the via insulating portion 22 may be measured using a cone-plate type rotational viscometer in accordance with JIS-Z8803:2011. The viscosity is measured at room temperature.

The viscosity of the composition for forming the via insulating portion 22 may be 100 dPa·s to 500 dPa·s. The viscosity may be 150 dPa·s or more. The viscosity may be 200 dPa·s or more. The viscosity may be 450 dPa·s or less. The viscosity may be 400 dPa·s or less. In these cases, it is possible to more smoothly fill the through-hole 11 with the composition for forming the via insulating portion 22 by screen printing.

The composition for forming the via insulating portion 22 may include an epoxy-based resin, a curing agent, and a filler.

The epoxy-based resin is the main component of the composition for forming the via insulating portion 22, and may provide the composition for forming the via insulating portion 22 with excellent adhesion and insulation properties along with low viscosity characteristics.

The epoxy-based resin may further include an additional functional group. For example, the epoxy-based resin may include any one selected from the group consisting of a bisphenol group, an aminophenol group, a naphthalene group, a novolac group, a glycidylamine group, and a combination thereof.

The curing agent may cause a crosslinking reaction at high temperatures to help form a via insulating portion from the composition for forming the via insulating portion 22.

Any one of a polyamine-based compound, an imidazole-based compound, and a combination thereof may be used as the curing agent.

For example, the polyamine-based compound includes modified polyamine originated from ethylenediamine, propylenediamine, butylenediamine, pentylenediamine, diethylenetriamine, and triethylenetetraamine.

For example, the imidazole-based compound includes methylimidazole, dimethylimidazole, benzylmethylimidazole, benzylphenylimidazole, and cyanoalkylimidazole.

The filler may adjust the viscosity of the composition for forming the via insulating portion 22 to be within a range desired in the embodiment, and may provide adjusted roughness to the via insulating portion.

The filler may be an inorganic filler. For example, silica, calcium carbonate, aluminum nitride, boron nitride, alumina, or magnesium oxide may be used as the filler.

The average particle diameter of the filler may be 0.1 µm to less than 15 µm. The average particle diameter may be 0.5 µm or more. The average particle diameter may be 1 µm or more. The average grain size may be 3 µm or more. The average grain size may be 5 µm or more. The average grain size may be 12 µm or less. The average particle diameter may be 10 µm or less. In these cases, the filler may have excellent dispersibility and may help the composition for forming the via insulating portion 22 to be easily filled into the through-hole 11 having the fine diameter. In addition, the surface of the via insulating portion may be enabled to have adjusted roughness characteristics, whereby the peel strength of an electrically conductive layer from the surface may be improved to a certain level or higher.

The average particle diameter of the filler is measured in accordance with JIS K 5600-2-5.

The composition for forming the via insulating portion 22 may include 4 wt% to 70 wt% of the epoxy-based resin. The composition for forming the via insulating portion 22 may include at least 10 wt% of the epoxy-based resin. The composition for forming the via insulating portion 22 may include at least 20 wt% of the epoxy-based resin. The composition for forming the via insulating portion 22 may include no more than 60 wt% of the epoxy-based resin.

The composition for forming the via insulating portion 22 may include 1 part by weight to 30 parts by weight of the curing agent based on 100 parts by weight of the epoxy-based resin. The composition for forming the via insulating portion 22 may include at least 3 parts by weight of the curing agent based on 100 parts by weight of the epoxy-based resin. The composition for forming the via insulating portion 22 may include at least 5 parts by weight of the curing agent based on 100 parts by weight of the epoxy-based resin. The composition for forming the via insulating portion 22 may include at least 10 parts by weight of the curing agent based on 100 parts by weight of the epoxy-based resin. The composition for forming the via insulating portion 22 may include no more than 25 parts by weight of the curing agent based on 100 parts by weight of the epoxy-based resin. The composition for forming the via insulating portion 22 may include no more than 20 parts by weight of the curing agent based on 100 parts by weight of the epoxy-based resin.

The composition for forming the via insulating portion 22 may include 20 wt% to 95 wt% of the filler. The composition for forming the via insulating portion 22 may include at least 30 wt% of the filler. The composition for forming the via insulating portion 22 may include at least 40 wt% of the filler. The composition for forming the via insulating portion 22 may include no more than 80 wt% of the filler.

In these cases, it is possible to form a via insulating portion having excellent filling properties for the through-hole 11 of the fine diameter and having excellent adhesion and insulation properties for the electrically conductive layer disposed in the through-hole 11.

The composition for forming the via insulating portion 22 may further include components other than the components described above. The other components are not restricted as long as the components can be generally used in the field of the composition for forming the via insulating portion. For example, materials added to the composition for forming the via insulating portion 22 include a thickener, a defoamer, an adhesion imparting agent or a leveling agent.

After filling the composition for forming the via insulating portion 22 into the through-hole 11 is completed, the screen 20 may be removed from an upper surface of the base substrate 100.

### 2) Curing process

In the curing process, the composition for forming the via insulating portion filled into the through-hole may be cured to form a via insulating portion, and a via-plugged substrate may be prepared.

The curing process may be performed by placing the base substrate having the composition for forming the via insulating portion injected into the through-hole into a chamber and leaving the base substrate in a hot atmosphere for a predetermined time.

The atmosphere temperature of the curing process may be 90 °C or higher. The atmosphere temperature may be 100 °C or higher. The atmosphere temperature may be 110 °C or higher. The atmosphere temperature may be 120 °C or higher. The atmosphere temperature may be 200 °C or lower. The atmosphere temperature may be 170 °C or lower.

The curing process may be performed for 15 minutes or more. The curing process may be performed for 20 minutes or more. The curing process may be performed for 60 minutes or less. The curing process may be performed for 50 minutes or less.

In these cases, the composition for forming the via insulating portion 22 filled into the through-hole may be sufficiently cured to form the via insulating portion.

### 3) Descum process

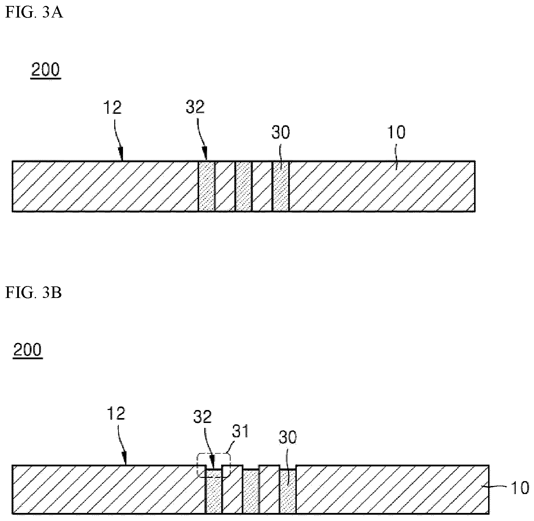

FIG. 3A is a conceptual view illustrating a via-plugged substrate after a descum process according to an embodiment of the present specification. Hereinafter, the embodiment will be described with reference to FIG. 3A.

A core layer 10 includes an upper surface 12 and a through-hole formed in the thickness direction of the core layer 10. The specific configuration of the core layer 10 is the same as described with reference to FIG. 1A. Hereinafter, differences will be described.

The via insulating portion forming step may further include a descum process of plasma-descumming a via-plugged substrate 200.

A via insulation portion 30 formed immediately after the filling process and the curing process may have a shape that protrudes from the upper surface 12 of the core layer. In the via insulating portion forming step of the present disclosure, the descum process may be further performed such that one end 32 of the via insulating portion located on the upper surface 12 side of the core layer is located at substantially the same height as the upper surface 12 of the core layer. This may enable a redistribution layer formed on the via-plugged substrate 200 to have excellent flatness.

At the same time, organic debris that is adsorbed to the surface of the substrate during the filling process and the curing process and is not easily removed by a cleaning solution may be effectively removed. In particular, when the core layer 10 is a glass core, efficient removal of organic residues is possible without excessive damage to the core layer 10 even though no special process is performed.

During the descum process, the via-plugged substrate 200 may be exposed to an O2 plasma atmosphere. The via-plugged substrate 200 may be exposed to the O2 plasma atmosphere for 2 to 10 minutes every time. The via-plugged substrate 200 may be exposed to the O2 plasma atmosphere 3 minutes or more every time. The via-plugged substrate 200 may be exposed to the O2 plasma atmosphere for 7 minutes or less every time.

During the descum process, the via-plugged substrate 200 may be exposed to the O2 plasma atmosphere once or more. The via-plugged substrate 200 may be exposed to the O2 plasma atmosphere twice or more. The via-plugged substrate 200 may be exposed to the O2 plasma atmosphere five times or more. The via-plugged substrate 200 may be exposed to the O2 plasma atmosphere 20 times or less. The via-plugged substrate 200 may be exposed to the O2 plasma atmosphere 10 times or less.

In these cases, one end 32 of the via insulating portion may be formed so as to have a height desired in the embodiment, and organic particles remaining on the surface of the via-plugged substrate 200 may be effectively removed.

FIG. 3B is a conceptual view illustrating a via-plugged substrate after a descum process according to another embodiment of the present specification.

A core layer 10 includes an upper surface 12 and a through-hole formed in the thickness direction of the core layer 10. The specific configurations of the core layer 10 and a via insulating portion 30 are the same as described with reference to FIGs. 1A and 3A. Hereinafter, differences will be described.

The via-plugged substrate 200 after the descum process may have a trench structure 31 in which one end 32 of a via insulating portion 30 is disposed lower than the upper surface 12 of the core layer 10. When an insulating layer (not shown) is formed on the via-plugged substrate 200 having the trench structure 31, an interlocking structure in which the formed insulating layer and the upper surface side of the via-plugged substrate 200 are reliably interlocked with each other may be formed, and the contact area between the insulating layer and the upper surface side of the via-plugged substrate 200 may be further increased, thereby improving adhesion of the insulating layer to the upper surface 12 of the substrate. At the same time, deterioration such as wrinkling of the insulating layer may not occur, whereby misalignment of a redistribution layer may be reliably inhibited.

The depth of the trench structure 31 may be measured using a surface roughness meter. If the surface of one end 32 of the via insulating portion is not flat, the difference between the average height of the profile of the upper surface of the via-plugged substrate 200 and the height at the point having the deepest depth of the profile of the trench structure 31 to be measured is designated to the depth of the trench structure 31.

The depth of the trench structure 31 may be measured by measuring the upper surface profile of the via-plugged substrate 200 in one of the in-plane directions of the via-plugged substrate 200 using the surface roughness meter.

The depth of the trench structure 31 may be measured by measuring the upper surface profile of the via-plugged substrate 200 in the x-axis direction and the y-axis direction among the in-plane directions of the via-plugged substrate 200 using the surface roughness meter. In this case, the greater one of the calculated depth values of the trench structure 31 is designated to the depth value of the trench structure 31.

For example, a surface roughness meter from Veeco may be used as the surface roughness meter.

The depth of the trench structure 31 may be 1 µm to 15 µm. The depth may be 12 µm or less. The depth may be 10 µm or less. The depth may be 3 µm or more. In these cases, the insulating layer formed on the core layer 10 may have a flat upper surface while exhibiting excellent adhesion to the upper surface 12 of the core layer.

### Cleaning step

The manufacturing method for the packaging substrate in the present disclosure may further include a cleaning step of cleaning the via-plugged substrate prepared by the via insulating portion forming step before the fabrication step.

In the cleaning step, the composition for forming the via insulating portion, remnants of the via insulating portion, and other organic particles that have not been removed during the descum process and remain on the surface of the substrate may be removed. This may inhibit poor connection of the electrically conductive layer caused by the particles.

The cleaning step may include an ultrasonic cleaning process of ultrasonically cleaning the via-plugged substrate.

In the ultrasonic cleaning process, the via-plugged substrate with residual organic particles may be immersed in a water bath, and ultrasonic vibration may be applied to the water bath to generate cavitation. This may facilitate the removal of adsorbed particles without excessive damage to the substrate.

In the cleaning step of the present disclosure, the vibration frequency may be 30 kHz to 200 kHz. The vibration frequency may be 50 kHz or higher. The vibration frequency may be 70 kHz or higher. The vibration frequency may be 100 kHz or higher. The vibration frequency may be 150 kHz or less. In these cases, even if the core layer 10 has a fine and complex pattern structure, it is possible to effectively clean the via-plugged substrate without significant damage thereto.

### Fabrication step

The manufacturing method for the packaging substrate in the present disclosure may further include a fabrication step of fabricating a packaging substrate from the via-plugged substrate.

In the fabrication step, a redistribution layer may be formed on and/or under the core layer. The redistribution layer may include an electrically conductive layer and an insulating layer configured to surround at least a part of the electrically conductive layer. In the redistribution layer, the insulating layer and the electrically conductive layer may be disposed in a mixture. The redistribution layer may be configured in the form of an electrically conductive layer having a predetermined position and shape embedded in the insulating layer. The electrically conductive layer may be formed in at least a part of the redistribution layer as a fine line.

The electrically conductive layer corresponds to a conducting wire configured to transmit an electrical signal. The electrically conductive layer may include an electrically conductive material. For example, the electrically conductive layer may include at least one of copper, nickel, aluminum, gold, and silver. Copper may be used as the material for the electrically conductive layer.

The electrically conductive layer may be formed using a dry method or a wet method. A description of the dry method and the wet method is identical to the foregoing and will therefore be omitted.

The insulating layer is not restricted as long as the insulating layer can be applied to a semiconductor element or a packaging substrate. For example, the insulating layer may be made of an epoxy-based resin including a filler. For example, the insulating layer may be made of a build-up layer material such as Ajinomoto build-up film (ABF) from Ajinomoto or an undercoat material; however, the embodiment is not limited thereto.

After the electrically conductive layer is formed, an insulating layer configured to surround the electrically conductive layer may be formed. The insulating layer may be formed by forming and curing a coating layer, or may be formed by laminating an insulator film in an uncured or semi-cured state onto the electrically conductive layer and curing the same. When the insulator film is laminated onto the electrically conductive layer by pressure-reduced lamination, the formed insulating layer may surround the electrically conductive layer without voids.

A multilayer redistribution layer may be formed by repeatedly forming and removing the insulating layer and the electrically conductive layer. The multilayer redistribution layer may be formed using a build-up layer method. Specifically, after forming a redistribution layer having a single layer, an unnecessary part of the insulating layer in the redistribution layer may be removed, an electrically conductive layer may be formed by plating or the like, and the electrically conductive layer may be selectively etched and patterned. Subsequently, an insulating layer may be laminated on the patterned electrically conductive layer to form a two-layer redistribution layer. The above process may be repeated to form a multilayer redistribution layer.

The redistribution layer may include a first redistribution layer formed on the core layer.

The first redistribution layer may include two or more electrically conductive layers. The first redistribution layer may include a first electrically conductive layer and a second electrically conductive layer disposed on the first electrically conductive layer.

The width of the second electrically conductive layer may be less than or equal to the width of the first electrically conductive layer. The width of the second electrically conductive layer may be less than the width of the first electrically conductive layer.

The thickness of the second electrically conductive layer may be less than or equal to the thickness of the first electrically conductive layer. The thickness of the second electrically conductive layer may be less than the thickness of the first electrically conductive layer.

The pitch of the second electrically conductive layer may be less than or equal to the pitch of the first electrically conductive layer. The pitch of the second electrically conductive layer may be less than the pitch of the first electrically conductive layer.

In the first redistribution layer having the multilayer structure, an electrically conductive layer having a smaller width may be disposed in an upward direction. In the first redistribution layer having the multilayer structure, an electrically conductive layer having a smaller thickness may be disposed in the upward direction. This may enable reliable electrical connection between the packaging substrate and a semiconductor element having a fine pattern.

The redistribution layer may include a second redistribution layer disposed under the core layer.

The second redistribution layer may include an electrically conductive layer and an insulating layer configured to surround the electrically conductive layer. The material and formation method of the electrically conductive layer and the insulating layer of the second redistribution layer may be the same as the material and formation method of the electrically conductive layer and the insulating layer of the first redistribution layer. A description of the electrically conductive layer and the insulating layer of the second redistribution layer is identical to the foregoing and will therefore be omitted.

The second redistribution layer may include two or more electrically conductive layers. The second redistribution layer may include a third electrically conductive layer and a fourth electrically conductive layer disposed under the one electrically conductive layer.

The width of the fourth electrically conductive layer may be greater than or equal to the width of the third electrically conductive layer. The width of the fourth electrically conductive layer may be greater than the width of the third electrically conductive layer.

The thickness of the fourth electrically conductive layer may be greater than or equal to the thickness of the third electrically conductive layer. The thickness of the fourth electrically conductive layer may be greater than the thickness of the third electrically conductive layer.

The pitch of the fourth electrically conductive layer may be greater than or equal to the pitch of the third electrically conductive layer. The pitch of the fourth electrically conductive layer may be greater than the pitch of the third electrically conductive layer.

In the second redistribution layer having the multilayer structure, an electrically conductive layer having a larger width may be disposed in a downward direction. In the second redistribution layer having the multilayer structure, an electrically conductive layer having a larger thickness may be disposed in the downward direction. This may enable reliable electrical connection between the packaging substrate and a main board having a wide or thick electrically conductive layer

The packaging substrate may further include a bump disposed under the second redistribution layer.

The bump may be disposed under the redistribution layer in a predetermined shape. For example, the bump may be disposed on a part of the lower surface of the packaging substrate so as to abut the main board, etc.

### Fabricated packaging substrate

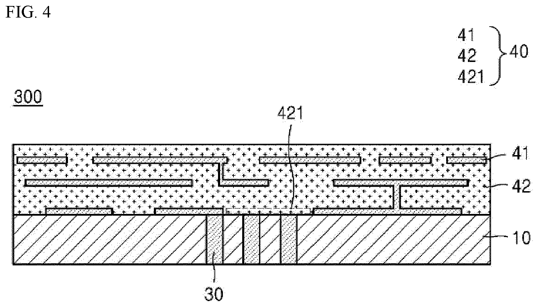

FIG. 4 is a sectional view illustrating a packaging substrate fabricated in accordance with an embodiment of the present specification. The embodiment will be described with reference to FIG. 4.

A core layer 10 includes an upper surface and a through-hole formed in the thickness direction of the core layer 10. A via insulating portion 30 may be formed in the through-hole. The specific configurations of the core layer 10 and the via insulating portion 30 are the same as described with reference to FIGs. 1A and 3A. Hereinafter, differences will be described.

The packaging substrate 300 fabricated in accordance with the manufacturing method for the packaging substrate in the present disclosure may include a core layer 10 having a through-hole formed in the thickness direction of the core layer 10 and a via insulating portion 30 disposed in the through-hole. The packaging substrate 300 may include a redistribution layer 40 disposed on and/or under the core layer 10. A description of the core layer 10, the via insulating portion 30, and the redistribution layer 40 is identical to the foregoing and will therefore be omitted.

The via insulating portion 30 may include a filler. The average particle diameter of the filler may be 0.1 µm to less than 15 µm. A description of the filler is identical to the foregoing and will therefore be omitted.

In the process of forming the redistribution layer 40 on or under the core layer 10 or in the process of driving the element, the packaging substrate 300 may be repeatedly exposed to a high temperature atmosphere. In particular, since the core layer 10 and the via insulating portion 30 made of different materials in the packaging substrate 300 have different thermal expansion properties, the via insulating portion 30 may stress the core layer 10 in the high temperature atmosphere. This stress may cause degradation of the electrical connection formed in the through-hole.

In the present disclosure, it is possible to adjust the mechanical properties of the via insulating portion 30 in order to inhibit the formation of defects in the packaging substrate 300 during repeated exposure to the high temperature atmosphere or during prolonged operation of the element. Specifically, it is possible to inhibit mechanical defects in the region near the through-hole in the core layer 10 and to prevent breakage of the electrically conductive layer due to thermal expansion of the via insulating portion 30 when the electrically conductive layer is disposed in the through-hole.

The Young's modulus of the via insulating portion 30 may be 3,000 MPa or more. The Young's modulus may be 3,500 MPa or more. The Young's modulus may be 4,000 MPa or more. The Young's modulus may be 4,500 MPa or more. The Young's modulus may be 8,000 MPa or less.

The tensile strength of the via insulating portion 30 may be 5 MPa or more. The tensile strength may be 10 MPa or more. The tensile strength may be 15 MPa or more. The tensile strength may be 50 MPa or less. The tensile strength may be 45 MPa or less.

The elongation of the via insulating portion 30 may be 0.1% to 5%. The elongation may be 4% or less. The elongation may be 3% or less. The elongation may be 2% or less. The elongation may be 1% or less.

In these cases, the packaging substrate 300 may have stable electrical reliability and long-term durability even when repeatedly exposed to the high-temperature atmosphere.

The Young's modulus of the via insulating portion 30 is measured at 30 °C by dynamic mechanical analysis (DMA). The tensile strength and elongation of the via insulating portion 30 are measured at 30 °C using a universal testing machine (UTM).

The packaging substrate 300 may further include an electrically conductive layer disposed between the via insulating portion 30 and a via inner-diameter surface. At least a part of the electrically conductive layer may be disposed abutting the via insulating portion 30. A description of the electrically conductive layer is identical to the foregoing and will therefore be omitted.

In the present disclosure, it is possible to adjust the peel strength of the electrically conductive layer from the surface of the via insulating portion 30 to be within a predetermined range such that the via insulating portion 30 reliably fixes and protects the electrically conductive layer and improves the electrical reliability of the packaging substrate 300.

The peel strength of the electrically conductive layer from the surface of the via insulating portion 30 is measured as follows. After a copper thin film having a thickness of 20 µm is formed on the surface of the via insulating portion 30, the peel strength of the copper thin film from the surface of the via insulating portion 30 is measured in accordance with a 180° peel test.

The peel strength of the electrically conductive layer from the surface of the via insulating portion 30 may be 4 N/cm or more. The peel strength may be 4.5 N/cm or more. The peel strength may be 5 N/cm or more. The peel strength may be 10 N/cm or less. In these cases, the via insulating portion 30 may contribute to inhibiting breakage of the electrically conductive layer formed in the through-hole.

In the present disclosure, it is possible to adjust the difference value in coefficient of thermal expansion between the via insulating portion 30 and the core layer 10 in order to inhibit physical defects in the core layer or damage to the electrically conductive layer in the through-hole due to the repeated thermal expansion of the via insulating portion 30.

The coefficient of thermal expansion of each of the via insulating portion 30 and the core layer 10 may be measured by thermomechanical analysis using a thermal mechanical analyzer (TMA). For example, the coefficient of thermal expansion may be measured using a model Q400 TMA from TA Instruments.

The coefficient of thermal expansion is measured in an atmosphere of 150 °C or lower.

The difference value between the coefficient of thermal expansion of the via insulating portion and the coefficient of thermal expansion of the core layer 10 is the absolute value of the coefficient of thermal expansion of the via insulating portion minus the coefficient of thermal expansion of the core layer 10.

The difference value between the coefficient of thermal expansion of the via insulating portion and the coefficient of thermal expansion of the core layer 10 may be 35 ppm/°C or less. The difference value may be 32 ppm/°C or less. The difference value may be 30 ppm/°C or less. The difference value may be 10 ppm/°C or more. In these cases, even if the core layer 10 has a complex structure and has high hardness characteristics, damage to the core layer 10 may not easily occur due to thermal expansion of the via insulating portion. In addition, if the electrically conductive layer is disposed in the through-hole, breakage of the electrically conductive layer in a high temperature atmosphere may be inhibited.

The packaging substrate 300 may further include a first insulating layer 421 formed in contact with at least part of the upper surface of the core layer 10. The dimple depth of the first insulating layer 421 may be 15 µm or less.

The first insulating layer 421 is at least part of the insulating layer 42 which is in contact with the upper surface of the core layer 10. That is, the first insulating layer 421 is included in the insulating layer 42.

A description of the material, formation method, etc. of the first insulating layer 421 is identical to the foregoing and will therefore be omitted.

In the packaging substrate 300 of the present disclosure, it is possible to adjust the dimple depth of the first insulating layer 421 to be within a specific range. The first insulating layer 421 having the above features may have flatness suitable for forming the first redistribution layer 40 having the multilayer structure, and may help the redistribution layer have excellent electrical reliability and reduce the frequency of misalignment in the redistribution layer to a certain level or lower.

The dimple depth of the first insulating layer 421 may be measured using a transmission electron microscope (TEM).

The dimple depth of the first insulating layer 421 may be 15 µm or less. The depth may be 12 µm or less. The depth may be 10 µm or less. The depth may be 7 µm or less. The depth may be 1 µm or more. In these cases, the first redistribution layer 40 with improved flatness may be formed.

The packaging substrate 300 may further include a second insulating layer (not shown) formed in contact with at least part of the lower surface of the core layer 10. The dimple depth of the second insulating layer may be 15 µm or less.

The second insulating layer is at least part of the insulating layer abutting the lower surface of the core layer 10. That is, the second insulating layer is included in the insulating layer.

A description of the material, formation method, etc. of the second insulating layer is identical to the foregoing and will therefore be omitted.

The dimple depth of the second insulating layer may be 15 µm or less. The depth may be 12 µm or less. The depth may be 10 µm or less. The depth may be 7 µm or less. The depth may be 1 µm or more. In these cases, the electrical reliability of the redistribution layer may be excellent even though the redistribution layer having the multilayer structure is formed.

Hereinafter, the embodiment will be described in more detail with reference to a specific example. The following example is merely provided for easy understanding of the present disclosure, and the scope of the embodiment is not limited thereto.

### Manufacturing Example: Fabrication of packaging substrate

Example 1: A defect was formed on the surface of a glass plate SG7.8 from Corning by laser irradiation, and wet etching was performed to form a plurality of through-holes, whereby a core layer was prepared. The inner diameter of each of the through-holes was adjusted to about 150 µm.

A screen targeting the plurality of through-holes was installed on the core layer, and the through-holes were filled with THP-100 DX1-450Ps ink from Daiyo, which is a composition for forming a via insulating portion, by screen printing. The average particle diameter of a filler included in the composition for forming the via insulating portion was less than 15 µm. The average particle diameter of the filler was measured as prescribed in JIS K5600-2-5.

The filled ink was cured at 140 °C for 30 minutes to form a via insulating portion, whereby a via-plugged substrate was prepared. The via-plugged substrate was placed in a chamber and subjected to plasma descum in which 5-minute exposure to an O2 plasma atmosphere is repeated a plurality of times. The substrate after descum was immersed in a water bath and was subjected to ultrasonic cleaning for 300 seconds at a vibration frequency of 100 kHz to complete a packaging substrate.

### Evaluation Example: Measurement of depth of trench structure of packaging substrate

Three of the through-holes located in each of an upper surface and a lower surface of the packaging substrate of the example were specified, and the surface profiles of the through-holes were measured using a surface roughness meter from Veeco. From the measured surface profiles, the average height value of an upper surface of the core layer (A value) and the height value of the lowest point in the through-hole (B value) were calculated, and the depth value of a trench structure was calculated by subtracting the B value from the A value.

The surface profile of each through-hole was measured once in an x-axis direction and once in a y-axis direction among in-plane directions of the upper surface of the core layer.

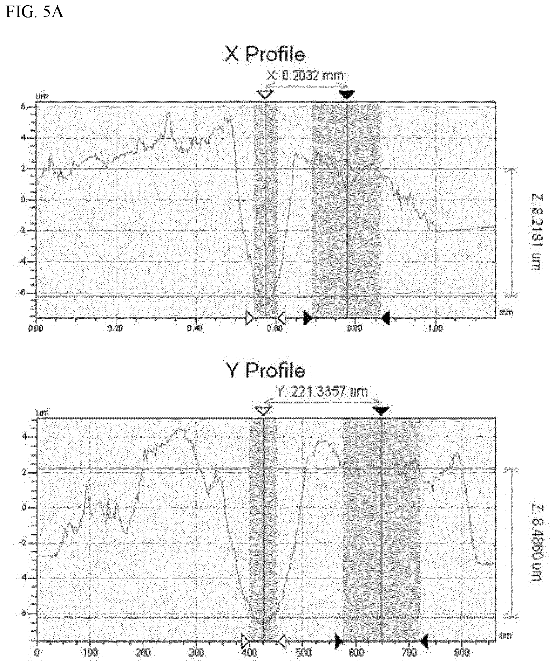

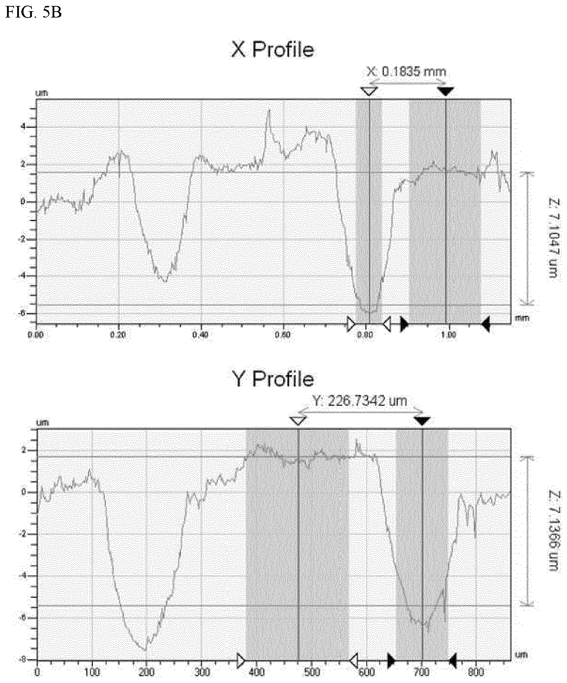

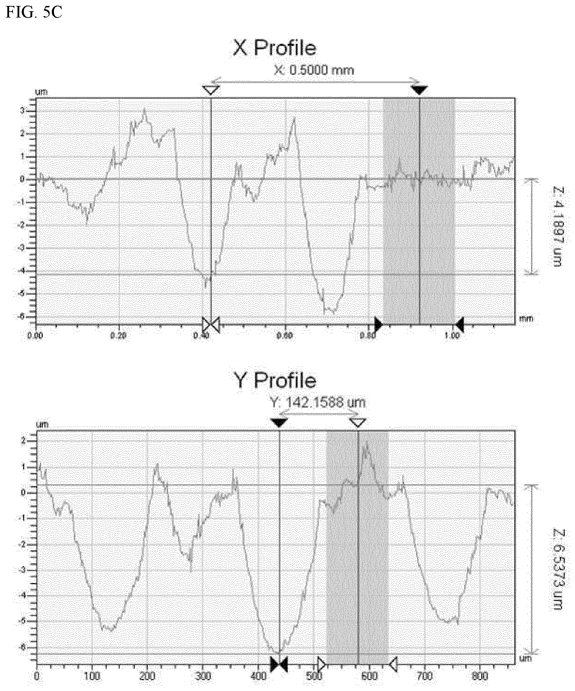

The profile of the trench structure for each through-hole located in the upper surface of the packaging substrate of the example is shown in FIGs. 5A to 5C, and the depth value of the trench structure is shown in Table 1 below.

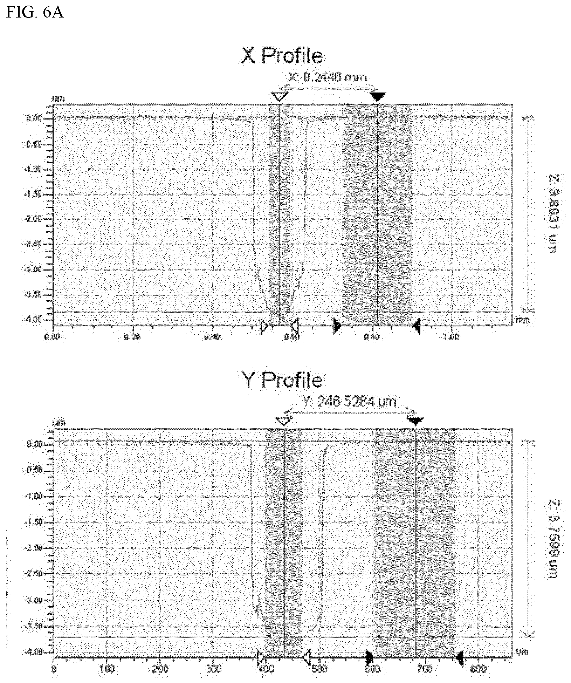

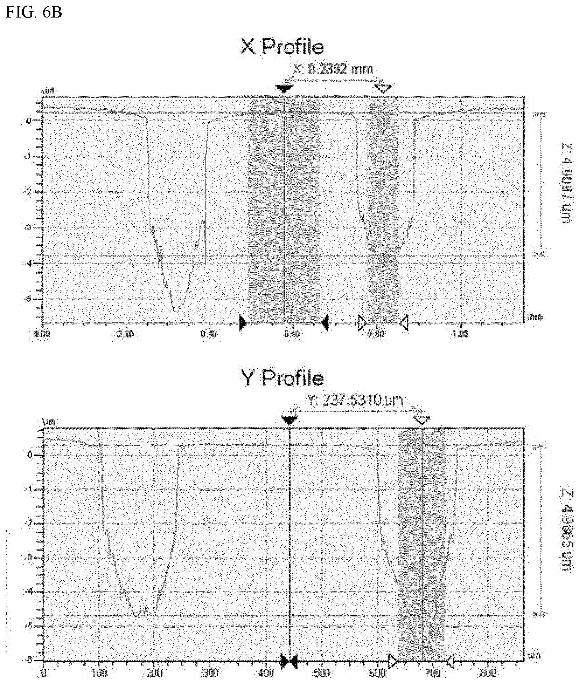

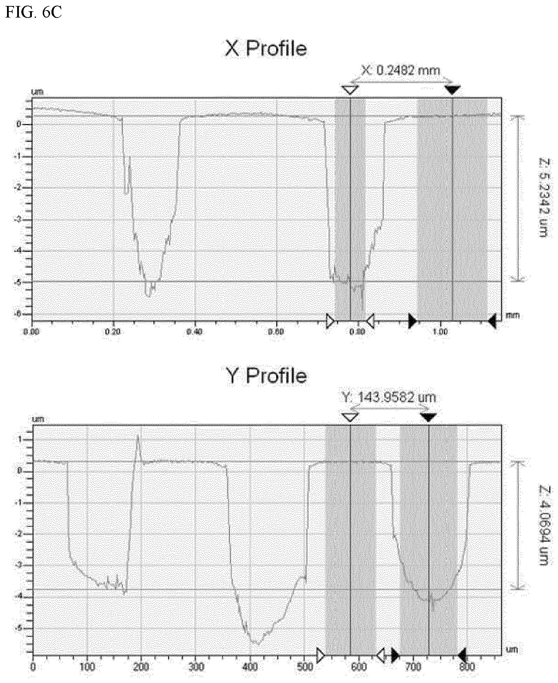

The profile of the trench structure for each through-hole located in the lower surface of the packaging substrate of the example is shown in FIGs. 6A to 6C, and the depth value of the trench structure is shown in Table 2 below.

### Evaluation Example: Dimple evaluation

An insulating layer was formed on the packaging substrate of the example. Specifically, an Ajinomoto build-up film (ABF) was laminated onto the upper surface of the core layer by pressure sensitive lamination to form an insulating layer.

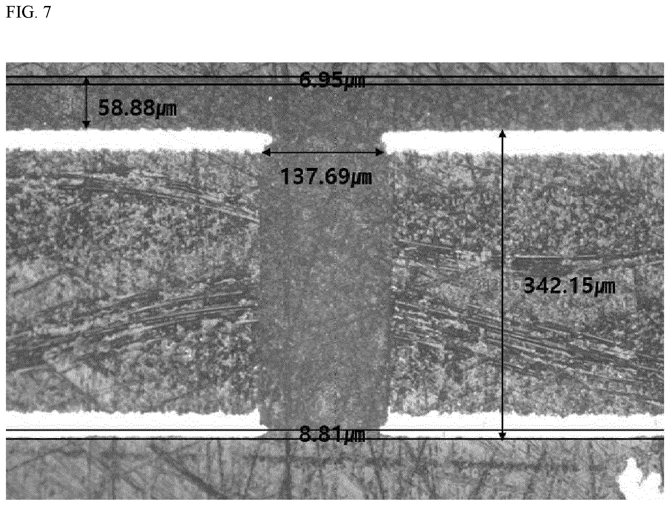

An image of the section of the packaging substrate having the insulating layer formed thereon was captured using a TEM to calculate the dimple depth. The TEM image of the packaging substrate having the insulating layer formed thereon is shown in FIG. 7.

### Evaluation Example: Physical properties of composition for forming via insulating portion and physical properties of via insulating portion

The viscosity of the composition for forming the via insulating portion used to fabricate the packaging substrate of the example was measured using a cone-plate type rotational viscometer in accordance with JIS-Z8803:2011.

The composition for forming the via insulating portion was coated to a flat plate and cured at 140 °C for 30 minutes to form a film-shaped via insulating portion. The Young's modulus of the via insulating portion was measured at 30 °C by DMA. In addition, the tensile strength and elongation of the via insulating portion were measured using a UTM.

A copper thin film having a thickness of 20 µm was formed on the via insulating portion, the peel strength of the copper thin film from the surface of the via insulating portion was measured in accordance with a 180° peel test.

The measured values of the composition for forming the via insulating portion and the measured values of the via insulating portion are shown in Table 3 below.

**[Table 1]**

| | Depth of trench structure of through-hole in upper surface | | |
|---|---|---|---|
| | First through-hole (nm) | Second through-hole (nm) | Third through-hole (nm) |
| x-axis direction | 8.22 | 7.10 | 4.19 |
| y-axis direction | 8.49 | 7.14 | 6.54 |

**[Table 2]**

| | Depth of trench structure of through-hole in lower surface | | |
|---|---|---|---|
| | First through-hole (nm) | Second through-hole (nm) | Third through-hole (nm) |
| x-axis direction | 3.89 | 4.00 | 5.23 |
| y-axis direction | 3.76 | 4.99 | 4.07 |

**[Table 3]**

| | Viscosity (dPa·s) | Young's modulus (MPa) | Tensile strength (MPa) | Elongation (%) | Peel strength (N/cm) |
|---|---|---|---|---|---|
| Composition for forming via insulating portion | 350 | - | - | - | - |
| Via insulating portion | - | 5,200 | 28 | 0.5 | 6.5 |

In the dimple evaluation, the measured dimple depth of the example was 10 µm or less. This indicates that the degree to which the insulating layer is sucked into the through-hole is adjusted, whereby the upper surface of the insulating layer can have excellent flatness.

In addition, it was observed from the TEM image shown in FIG. 7 that no voids were formed in the through-hole. This indicates that, when the electrically conductive layer is formed on the via inner-diameter surface, the via insulating portion can reliably fix and protect the electrically conductive layer.

Although the preferred embodiments have been described in detail above, the scope of the present disclosure is not limited thereto, and various modifications and improvements by those skilled in the art utilizing the basic concepts of the present disclosure defined in the following claims are also within the scope of the present disclosure.

## Claims

1. A manufacturing method for a packaging substrate, comprising:
a preparation step of preparing a base substrate comprising a core layer comprising an upper surface and a through-hole formed in a thickness direction of the core layer;
a via insulating portion forming step of forming a via insulating portion in the through-hole to prepare a via-plugged substrate; and
a fabrication step of fabricating the packaging substrate from the via-plugged substrate.

2. The manufacturing method of claim 1, wherein
the core layer is a glass core,
the through-hole is formed in the core layer in two or more,
the through-hole has a diameter of 40 µm to 200 µm, and
the through-hole has a pitch of 50 µm to 1,500 µm.

3. The manufacturing method of claim 1, wherein
the via insulating portion forming step comprises: a filling process of filling the through-hole with a composition for forming the via insulating portion by screen printing; and a curing process of curing the composition for forming the via insulating portion to form the via insulating portion, and
the composition for forming the via insulating portion has a viscosity of 100 dPa·s to 500 dPa·s.

4. The manufacturing method of claim 3, wherein the via insulating portion forming step further comprises a descum process of plasma-descumming the via-plugged substrate.

5. The manufacturing method of claim 1, wherein
the via insulating portion comprises one end located on an upper surface side of the core layer, and
the via-plugged substrate has a trench structure in which the one end of the via insulating portion is located lower than the upper surface of the core layer.

6. The manufacturing method of claim 5, wherein the trench structure of the via-plugged substrate has a depth of 1 µm to 15 µm.

7. The manufacturing method of claim 1, wherein
the packaging substrate comprises the core layer having the through-hole formed in the thickness direction of the core layer and the via insulating portion formed in the through-hole,
the via insulating portion comprises a filler, and
the filler has an average particle diameter of 0.1 µm to less than 15 µm.

8. The manufacturing method of claim 1, wherein the via insulating portion has an elongation of 0.1% to 5%.

9. The manufacturing method of claim 1, wherein a composition for forming the via insulating portion comprises an epoxy-based resin, a curing agent, and a filler.

10. The manufacturing method of claim 1, wherein
the packaging substrate comprises the core layer having the through-hole formed in the thickness direction of the core layer, the via insulating portion formed in the through-hole, and a first insulating layer formed in contact with at least part of the upper surface of the core layer, and
the first insulating layer has a dimple depth of 15 µm or less.
